# EUROPÄISCHE PATENTSCHRIFT

(11) **EP 0 996 982 B1**
(45) Veröffentlichungstag und Bekanntmachung des Hinweises auf die Patenterteilung: **29.10.2008**
(21) Anmeldenummer: 98945002.8
(22) Anmeldetag: 16.07.1998
(51) Int. Cl.: H01L 29/78, H01L 21/336

(54) **VERFAHREN ZUR HERSTELLUNG EINES VERTIKALEN MOS-TRANSISTORS**
METHOD FOR MAKING A VERTICAL MOS TRANSISTOR
PROCEDE POUR LA FABRICATION D'UN TRANSISTOR MOS VERTICAL

(30) Priorität: 18.07.1997 DE 19730971
(43) Veröffentlichungstag der Anmeldung: 03.05.2000
(73) Patentinhaber: Infineon Technologies AG, 81669 München (DE)
(72) Erfinder: SCHULZ, Thomas, D-81739 München (DE); AEUGLE, Thomas, D-81735 München (DE); RÖSNER, Wolfgang, D-81739 München (DE); RISCH, Lothar, D-85579 Neubiberg (DE)
(74) Vertreter: Müller - Hoffmann & Partner
(86) Internationale Anmeldenummer: PCT/DE1998/002000
(87) Internationale Veröffentlichungsnummer: WO 1999/004436

(56) Entgegenhaltungen:
- EP-A- 0 721 221
- DE-A- 19 621 244
- US-A- 4 648 937
- US-A- 5 177 027
- US-A- 5 504 359
- RISCH L ET AL: "VERICAL MOS TRANSISTORS WITH 70NM CHANNEL LENGTH" IEEE TRANSACTIONS ON ELECTRON DEVICES, Bd. 43, Nr. 9, September 1996, Seiten 1495-1498, XP000636266

## Beschreibung

Die Erfindung betrifft einen vertikalen MOS-Transistor mit besonders kleiner Kanallänge und guten Hochfrequenz- und Logikeigenschaften.

Im Hinblick auf immer schnellere Bauelemente bei höherer Integrationsdichte nehmen die Strukturgrößen integrierter Schaltungen von Generation zu Generation ab. Dieses gilt auch für die CMOS-Technologie. Es wird allgemein erwartet (siehe zum Beispiel Roadmap of Semiconductor Technology, Solid State Technology 3, (1995)), daß um das Jahr 2010 MOS-Transistoren mit einer Gatelänge von weniger als 100 nm eingesetzt werden.

Einerseits wird versucht, durch Skalierung der heute üblichen CMOS-Technologie planare MOS-Transistoren mit derartigen Gatelängen zu entwickeln (siehe zum Beispiel A. Hori, H. Nakaoka, H. Umimoto, K. Yamashita, M. Takase, N. Shimizu, B. Mizuno, S. Odanaka, A 0,05 µm-CMOS with Ultra Shallow Source/Drain Junctions Fabricated by 5 keV Ion Implantation and Rapid Thermal Annealing, IEDM 1994, 485 und H. Hu, L. T. Su, Y. Yang, D. A. Antoniadis, H. I. Smith, Channel and Source/Drain Engineering in High-Performance sub-0,1 µm NMOSFETs using X-Ray lithography, Sympl. VLSI Technology, 17, (1994)). Derartige planare MOS-Transistoren mit Kanallängen unter 100 nm herzustellen, erfordert den Einsatz von Elektronenstrahllithographie und ist bisher nur im Labormaßstab möglich. Der Einsatz der Elektronenstrahllithographie führt zu einer überproportionalen Steigerung der Herstellungskosten.

Parallel dazu werden vertikale Transistoren untersucht. Da die Kanallänge bezüglich einer Oberfläche eines Substrats vertikal verläuft, kann die Fläche eines vertikalen Transistors kleiner sein als die herkömmlicher planarer Transistoren. Eine weitere Verkleinerung der Fläche erzielt man durch Verkleinerung der für eine bestimmte Stromstarke nötigen Kanalweite, indem die Kanallänge verkürzt wird. In L. Risch, W. H. Krautschneider, F. Hofmann, H. Schäfer, Vertical MOS Transistor with 70 nm channel length, ESSDERC 1995, Seite 101 bis 104 werden vertikale MOS-Transistoren mit kurzen Kanal langen beschrieben. Zu ihrer Herstellung werden Schichtenfolgen entsprechend Source, Kanal und Drain gebildet, die ringförmig von Gatedielektrikum und Gateelektrode umgeben sind. Die Kanallänge der vertikalen MOS-Transistoren sind im Vergleich zu der herkömmlicher planarer Transistoren klein. Die vertikalen MOS-Transistoren sind im Vergleich zu planaren MOS Transistoren bezüglich ihrer Hochfrequenz- und Logikeigenschaften bisher unbefriedigend. Dieses wird einerseits auf parasitäre Kapazitäten der überlappenden Gateelektrode und andererseits auf die Ausbildung eines parasitären Bipolartransistors in der vertikalen Schichtenfolge zurückgeführt.

In H. Takato et al IEDM 88, Seiten 222 bis 225, wird ein vertikaler MOS-Transistor beschrieben, dessen Gateelektrode eine quaderförmige Schichtstruktur, in der ein erstes Source/Drain-Gebiet und eine Kanalschicht angeordnet sind, ringförmig umgibt. Durch die ringförmige Anordnung der Gateelektrode wird die Raumladungszone vergrößert, was eine Verringerung der parasitären Kapazität zur Folge hat. Die Kanallänge des MOS-Transistors ist groß und entspricht der herkömmlicher planarer Transistoren. Die Schichtstruktur wird durch ein lithographisches Verfahren erzeugt und weist vorzugsweise eine laterale Breite von ca. 1 µm auf, damit die Raumladungszone die ganze Kanalschicht ausfüllt. Die Hochfrequenz- und Logikeigenschaften des vertikalen MOS-Transistors sind damit mit denen planarer MOS-Transistoren vergleichbar.

Aus Risch L et al.: "Vertical MOS Transistors with 70nm Channel Length" IEEE Transactions on Electron Devices, Bd. 43, Nr. 9, September 1996 (1996-09), Seiten 1495-1498, XP000636266, ist die Herstellung eines vertikalen MOSFETs durch einen Ätzprozess bekannt. Dabei werden ein erstes Source/Drain-(S/D-)Gebiet am Boden eines Trenches und ein darunterliegender Kanal freigelegt. Ein Gate wird an gegenüberliegenden Flanken einer Mesa erzeugt, und auf der Mesa wird ein zweites S/D-Gebiet gebildet.

Weiterhin ist die Verwendung eines Spacers für die Ätzung von Graben und Mesastrukturen mit kleinen lateralen Abmessung aus der EP-A-0721221 und der US-A-4648937 bekannt.

Der Erfindung liegt das Problem zugrunde, ein Verfahren zur Herstellung eines vertikalen MOS-Transistors anzugeben, bei dem die Hochfrequenz- und Logikeigenschaften des vertikalen MOS-Transistors mit denen planarer MOS-Transistoren vergleichbar und die Kanallänge des vertikalen MOS-Transistors besonders klein werden.

Dieses Problem wird gelöst durch ein Verfahren gemäß Anspruch 1. Weitere Ausgestaltungen der Erfindung gehen aus den übrigen Ansprüchen hervor.

Im folgenden bedeutet "a ist oberhalb von b" nicht notwendigerweise, daß a an b angrenzt. Es kann auch etwas zwischen a und b angeordnet sein.

In einem erfindungsgemäßen Verfahren wird ein vertikaler MOS-Transistor gebildet, der ein erstes Source/Drain-Gebiet und eine Kanalschicht in einer Schichtstruktur aufweist. Zumindest im Bereich der Kanalschicht wird die Schichtstruktur mindestens beidseitig, d.h. mindestens an zwei gegenüberliegenden Flanken der Schichtstruktur, mit einem Gatedielektrikum und einer Gateelektrode versehen. Ein erster Teil der Gateelektrode, der an eine erste der zwei gegenüberliegenden Flanken angrenzt, und ein zweiter Teil der Gateelektrode, der an eine zweite der zwei gegenüberliegenden Flanken angrenzt, werden z.B. über einen Kontakt oder einen Steg miteinander verbunden. Die Gateelektrode kann auch zusammenhängend ausgebildet werden. Im Gegensatz zu einer einseitigen Anordnung wird bei der beidseitigen Anordnung ohne daß sich die Fläche des vertikalen MOS-Transistors deswegen vergrößert die Kanalweite verdoppelt und damit der Strom erhöht und die Ausbildung von Raumladungszonen zwischen den zwei Flanken in der Kanalschicht vergrößert. Dies ist vorteilhaft, da in Raumladungszonen keine Leckströme aufgrund eines parasitären Bipolartransistors entstehen.

Raumladungszonen werden umso größer, je niedriger die Dotierstoffkonzentration der Kanalschicht ist. Da aber eine kurze Kanallänge erzeugt werden soll, muß die Kanalschicht hoch dotiert werden, um Leckströme aufgrund von Punch-Through zu vermeiden. Um innerhalb der gesamten Kanalschicht eine Raumladungszone zu erhalten, muß demnach eine Abmessung zwischen den zwei gegenüberliegenden Flanken der Schichtstruktur besonders klein werden. Dazu wird die Schichtstruktur mit Hilfe eines als Maske dienenden Spacers erzeugt. Die Abmessung zwischen den zwei gegenüberliegenden Flanken der Schichtstruktur wird so klein, daß bei entsprechender Ansteuerung der Gateelektrode der vertikale MOS-Transistor vollständig verarmt. Bei einer üblichen Spannung von 0V-2V beträgt damit die Abmessung ca. 30nm-90nm.

Ein zweites Source/Drain-Gebiet kann als Teil der Schichtstruktur unter der Kanalschicht angeordnet sein. Es ist vorteilhaft, wenn das zweite Source/Drain-Gebiet nicht Teil der Schichtstruktur ist, sondern im wesentlichen lateral zur Schichtstruktur erzeugt wird. Dadurch können zum einen das hochdotierte erste Source/Drain-Gebiet und das hochdotierte zweite Source/Drain-Gebiet durch Implantation selbstjustiert, d.h. ohne Verwendung von zu justierenden Masken, erzeugt werden. Das erste Source/Drain-Gebiet ist dabei über der Kanalschicht angeordnet. Zum anderen kann die Kanalschicht mit einem Substrat aus Halbleitermaterial verbunden werden, was Floating-Body Effekte der Kanalschicht verhindert, falls diese nicht vollständig verarmt sein sollte. In diesem Fall ist das Substrat in einer Schicht, die an die Kanalschicht angrenzt, vom Leitfähigkeitstyp der Kanalschicht dotiert. Der Leitfähigkeitstyp der Schicht kann aber auch unabhängig vom Leitfähigkeitstyp der Kanalschicht gewählt werden. Der Leitfähigkeitstyp des ersten Source/Drain-Gebiets und des zweiten Source/Drain-Gebiets kann mit dem Leitfähigkeitstyp der Kanalschicht vertauscht werden.

Das zweite Source-Drain-Gebiet kann auch als Teil der Schichtstruktur ausgebildet sein und/oder von unten an die Kanalschicht angrenzen.

Es liegt im Rahmen der Erfindung die Schichtstruktur durch Strukturierung einer Schichtenfolge zu erzeugen. Für die Schichtenfolge wird mindestens eine von einem zweiten Leitfähigkeitstyp dotierte erste Schicht für die Kanalschicht und eine von einem ersten, zum zweiten Leitfähigkeitstyp entgegengesetzten Leitfähigkeitstyp dotierte zweite Schicht für das erste Source-Drain-Gebiet erzeugt. Wenn der vertikale MOS-Transistor in eine Schaltungsanordnung mit mehreren Bauelementen integriert werden soll, so kann es günstig sein, für die Schichtenfolge zusätzliche Schichten zu erzeugen.

Die Schichtenfolge kann auf einer Oberfläche des Substrats ganzflächig durch epitaktisches Aufwachsen von in situ dotiertem Halbleitermaterial erzeugt werden. Es kann auch eine Vertiefung im Substrat erzeugt werden, in der durch epitaktisches Aufwachsen die Schichtenfolge erzeugt wird. Es kann auch ein Material auf die Oberfläche abgeschieden werden, in dem eine Vertiefung erzeugt wird, die bis zur Oberfläche reicht, und in der die Schichtenfolge durch epitaktisches Aufwachsen erzeugt wird. Beim epitaktischen Aufwachsen der Schichtenfolge in einer Vertiefung bilden sich an Rändern der Vertiefung Facetten, da an diesen Rändern die Aufwachsrate bei der selektiven Epitaxie geringer ist. Die Schichten werden dadurch besonders dünn, was zu einer besonders kleinen Kanallänge führt. Die Schichtenfolge kann auch durch Implantation mit jeweils unterschiedlich geladenen Ionen und unterschiedlicher Reichweite erzeugt werden. In diesem Fall ist epitaktisches Aufwachsen nicht notwendig und für die Schichtenfolge kann das Substrat strukturiert werden. Die Schichtenfolge kann eine Siliziumschicht und/oder eine Si(₁₋ₓ)Geₓ-Schicht enthalten.

Zur Erzeugung des Spacers ist es vorteilhaft, eine Kante zu bilden, entlang der durch Abscheiden und Rückätzen von Material der Spacer entsteht. Die Kante kann durch Abscheiden und Strukturieren einer ersten Hilfsschicht oberhalb der Schichtenfolge erzeugt werden. Die Kante kann auch durch maskiertes Ätzen der Schichtenfolge entstehen.

Die Schichtstruktur kann stegförmig ausgebildet werden. Es liegt im Rahmen der Erfindung, wenn die Schichtstruktur entlang einer Grenzlinie eines eckigen oder kreisförmigen inneren Bereichs des Substrats gebildet wird. Dazu kann die Kante so gebildet werden, dass eine Flache des inneren Bereichs tiefer als die Umgebung liegt oder höher als die Umgebung liegt. Es liegt im Rahmen der Erfindung die Schichtstruktur entlang eines komplizierteren Linienmusters, wie z.B. die Grenzlinien eines Rechtecks zusammen mit stegförmigen Ausläufern an den Seiten des Rechtecks, zu bilden.

Es ist vorteilhaft, die Gateelektrode als Spacer auszubilden, da so die Gateelektrode klein wird und selbstjustiert erzeugt werden kann.

Zur Kontaktierung der Gateelektrode ist es vorteilhaft, in einem Bereich der Schichtstruktur einen Teil der zweiten Schicht zu entfernen. In diesem Bereich wird anschließend die Gateelektrode durch einen ersten Kontakt kontaktiert. Da der Teil der zweiten Schicht in diesem Bereich entfernt wurde, wird die Ausbildung einer unerwünschten Kapazität zwischen der Gateelektrode und dem ersten Source/Drain-Gebiet vermieden. Da die Schichtstruktur entlang der Grenzlinie des inneren Bereichs ausgebildet ist, wird durch die Kontaktierung ein Teil der Gateelektrode im inneren Bereich mit einem Teil der Gateelektrode außerhalb des inneren Bereichs elektrisch verbunden. Die Gateelektrode wird zusammenhangend gebildet.

Um die Gateelektrode zusammenhangend auszubilden, kann statt dessen ein Teil der Schichtstruktur entfernt werden, so, dass die Schichtstruktur den inneren Bereich nicht vollständig umgibt. Durch Abscheiden und Rückätzen von Polysilizium bildet sich dadurch die Gateelektrode zusammenhangend aus.

Alternativ kann der Teil der Gateelektrode im inneren Bereich und der Teil der Gateelektrode außerhalb des inneren Bereich dadurch verbunden werden, daß eine leitende Struktur erzeugt wird, die u-förmig an die zwei gegenüberliegenden Flanken und an eine bezüglich den zwei gegenüberliegenden Flanken senkrechte Fläche der Schichtstruktur angrenzt. Um die Ausbildung der unerwünschten Kapazität zwischen der Gateelektrode und dem ersten Source/Drain-Gebiet zu vermeiden, ist es in diesem Fall vorteilhaft, den Spacer in einem Bereich nicht zu entfernen, zusätzliche Spacer, die die Flanken der Schichtstruktur bedecken zu erzeugen und in diesem Bereich die u-förmige leitende Struktur zu erzeugen. Dadurch wird ein Abstand zwischen der u-förmigen leitenden Struktur und dem ersten Source/Drain-Gebiet groß und die zugehörige Kapazität klein. Die u-förmige leitende Struktur kann gleichzeitig mit der Gateelektrode erzeugt werden, indem Material abgeschieden und mit Hilfe einer Maske, die den Bereich abdeckt, geätzt wird, bis die Gateelektrode in Form eines Spacers entsteht. Ein nichtgeätzter Teil des Materials bildet die u-förmige leitende Struktur.

Zur Verkleinerung der Fläche des vertikalen MOS-Transistors wird ein dritter Kontakt des zweiten Source/Drain-Gebiets innerhalb des inneren Bereichs angeordnet. Dazu wird das zweite Source/Drain-Gebiet so gebildet, daß ein erster Teil des zweiten Source/Drain-Gebiets mit dem inneren Bereich zusammenfällt. Nach Erzeugung der Gateelektrode wird isolierendes Material abgeschieden und zurückgeätzt, wodurch eine erste isolierende Struktur in Form von Spacern entsteht, die die Gateelektrode bedeckt. Der erste Teil des zweiten Source/Drain-Gebiets im inneren Bereich wird dabei teilweise freigelegt. Auf dem ersten Teil des zweiten Source/Drain-Gebiets wird durch Abscheiden und Rückätzen von leitendem Material ein dritter Kontakt gebildet. Gleichzeitig wird auch ein zweiter Kontakt gebildet das erste Source/Drain-Gebiet kontaktiert.

Es ist vorteilhaft, vor der Kontaktierung des zweiten Source/Drain-Gebiets und des ersten Source/Drain-Gebiets Metall abzuscheiden und zu silizieren. Eine dabei entstehende Kontaktstruktur aus Metallsilizid verkleinert den elektrischen Widerstand beim Übergang zwischen dem jeweiligen Source/Drain-Gebiet und der zugehörigen Kontaktierung.

Zur Vereinfachung des Herstellungsverfahrens ist es vorteilhaft, für isolierende Strukturen und für eine Schutzschicht, die aneinander angrenzen, unterschiedliche isolierende Materialien zu verwenden, da so selektive Ätzschritte durchgeführt werden können.

Zur besseren Kontaktierung des ersten Source/Drain-Gebiets ist es vorteilhaft, die Schichtstruktur so zu erzeugen, daß sie in einem Bereich besonders breit wird. Dazu bedeckt eine Maske diesen Bereich bei der Erzeugung des Spacers.

Es ist vorteilhaft über das zweite Source/Drain-Gebiet eine Schutzschicht zu erzeugen, um eine Kapazität zu verkleinern, die durch die Gateelektrode und das zweite Source/Drain-Gebiet gebildet wird.

Im folgenden werden Beispiele zur Erläuterung der Erfindung und ein Ausführungsbeispiel der Erfindung, die in den Figuren dargestellt sind, näher erläutert.
- Figur 1: zeigt einen Querschnitt durch ein erstes Substrat, auf dessen Oberfläche eine erste Schicht und eine zweite Schicht epitaktisch aufgewachsen wurden, nachdem auf einer Oberfläche der zweiten Schicht eine erste Hilfsschicht strukturiert und aus einer zweiten Hilfsschicht ein Spacer erzeugt wurde.
- Figur 2: zeigt den Querschnitt aus Figur 1, nachdem eine Schichtstruktur, ein erstes Source/Drain-Gebiet, ein zweites Source/Drain-Gebiet, eine Schutzschicht, ein Gatedielektrikum, eine Gateelektrode und ein erster Kontakt erzeugt wurden.

- Figur 3: zeigt den Querschnitt aus Figur 2, nachdem das erste Source/Drain-Gebiet durch Schrägimplantaion erweitert wurde und eine erste isolierende Struktur und eine Kontaktstruktur erzeugt wurden.
- Figur 4: zeigt einen Querschnitt durch ein zweites Substrat, nachdem eine Schichtstruktur, ein erstes Source/Drain-Gebiet, ein zweites Source/Drain-Gebiet, eine Schutzschicht, ein Gatedielektrikum, eine Gateelektrode, ein erster Kontakt und eine erste isolierende Struktur erzeugt wurden.
- Figur 5: zeigt den Querschnitt aus Figur 4, nachdem Kontaktstrukturen, ein zweiter Kontakt, ein dritter Kontakt und eine zweite isolierende Struktur erzeugt wurden.
- Figur 6: zeigt einen Ausschnitt aus einer zum Querschnitt aus Figur 5 zugehörigen Draufsicht.
- Figur 7: zeigt einen Ausschnitt aus einer Draufsicht auf ein drittes Substrat, das einen Transistor umfaßt. Dargestellt sind ein zweites Source/Drain-Gebiet, eine Schichtstruktur, ein erster Kontakt, ein zweiter Kontakt, ein dritter Kontakt, ein innerer Bereich und ein erster Bereich.
- Figur 8: zeigt einen Querschnitt durch das dritte Substrat, nachdem ein zeites Source/Drain-Gebiet, eine erste Schicht, eine zweite Schicht, ein Spacer, und eine Schichtstruktur erzeugt wurden.
- Figur 9: zeigt den Querschnitt aus Figur 8, nachdem zweite Spacer, eine Schutzschicht, ein Gatedielektrikum (in dieser Figur nicht sichtbar) und eine Gateelektrode erzeugt wurden.
- Figur: 10 zeigt einen zu Figur 9 parallelen Querschnitt.

Die Figuren sind nicht maßstäblich.

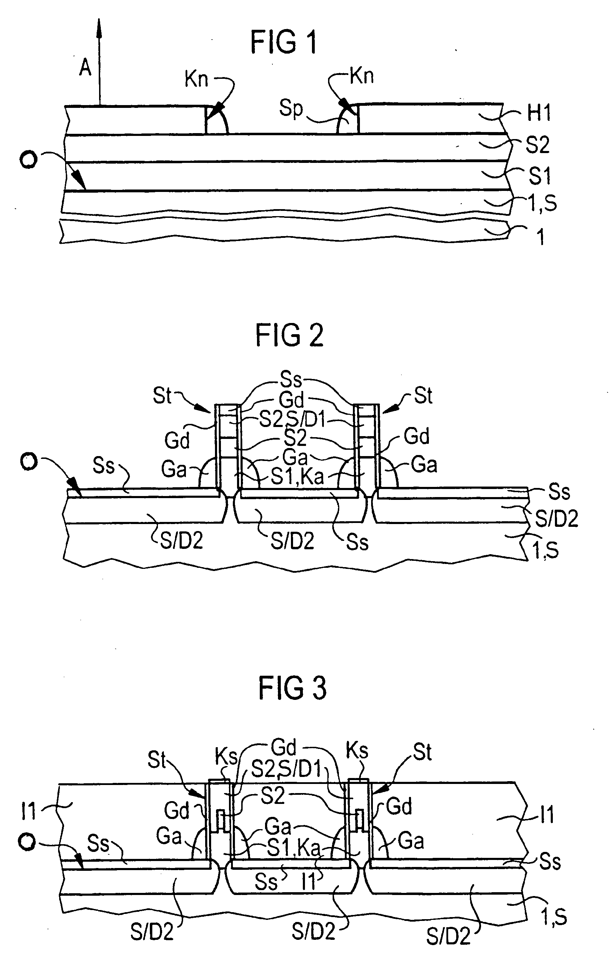

Gemäß eines Beispiels zur Erläuterung der Erfindung ist ein erstes Substrat 1 aus Silizium in einer an eine Oberfläche O des ersten Substrats 1 angrenzenden ca. 400µm dicken Schicht S n-dotiert (s. Fig. 1). Die Dotierstoffkonzentration beträgt ca. 10¹⁵cm⁻³. Durch Epitaxie wird auf einer Oberfläche O des Substrats 1 ganzflächig als Teil einer Schichtenfolge eine n-dotierte erste Schicht S1 aufgewachsen. Die Dotierstoffkonzentration der ersten Schicht S1 beträgt ca. 10¹⁸cm⁻³. Über der ersten Schicht S1 wird anschließend durch Epitaxie als Teil der Schichtenfolge eine p-dotierte zweite Schicht S2 aufgewachsen. Die Dotierstoffkonzentration der zweiten Schicht S2 beträgt ca. 5*10¹⁹cm⁻³. Über der zweiten Schicht S2 wird in einer Dicke von ca. 200nm eine erste Hilfsschicht H1 aus SiO₂ abgeschieden. Mit Hilfe einer ersten Maske auf Photolack, die einen rechteckigen inneren Bereich einer Oberfläche der ersten Hilfsschicht H1 nicht bedeckt, wird die erste Hilfsschicht H1 so strukturiert, daß ein Teil einer Oberfläche der zweiten Schicht S2 freigelegt wird. Als Ätzmittel ist z.B. CHF₃/O₂ geeignet. An Rändern des inneren Bereichs bildet sich dadurch eine Kante Kn. Anschließend wird in einer Dicke von ca. 70nm eine zweite Hilfsschicht (nicht dargestellt) aus Siliziumnitrid abgeschieden und rückgeätzt, so, daß sich an der Kante Kn ein Spacer Sp bildet (s. Fig. 1). Anschließend wird selektiv zu Siliziumnitrid zunächst SiO₂ mit z.B. NH₄F/HF naß geätzt und dann Silizium mit z.B. HBr/NF₃/O₂/He anisotrop geätzt, bis die Oberfläche O freigelegt wird. Da der Spacer Sp eine Breite von ca. 70nm aufweist, entsteht dadurch aus der Schichtenfolge eine ca. 70nm breite Schichtstruktur St entlang den Rändern des inneren Bereichs (s. Fig. 2).

Mit Hilfe von heißer Phosphorsäure als Ätzmittel wird anschließend der Spacer Sp entfernt. Mit Hilfe einer zweiten Maske aus Photolack, die eine erste Ecke des inneren Bereichs nicht bedeckt, wird ein Teil der zweiten Schicht S2 der Schichtstruktur St entfernt.

Anschließend werden durch Implantation in der strukturierten zweiten Schicht S2 ein p-dotiertes erstes Source/Drain-Gebiet S/D1 und unter der Oberfläche O ein p-dotiertes zweites Source/Drain-Gebiet S/D2 erzeugt (s. Fig. 2). Die Dotierstoffkonzentration beträgt ca. 10²¹cm⁻³. Das zweite Source/Drain-Gebiet S/D2 wird dadurch selbstjustiert lateral angrenzend an die Schichtstruktur St gebildet. Die strukturierte erste Schicht S1 ist als Kanalschicht Ka geeignet. Die Kanalschicht Ka grenzt an die Schicht S an, wodurch Floating-Body Effekte der Kanalschicht Ka verhindert werden.

Anschließend wird SiO₂ in einer Dicke von ca. 250nm anisotrop aufgebracht, wodurch bezüglich einer Achse A, die senkrecht zur Oberfläche O verläuft, senkrechte Flächen dicker mit SiO₂ bedeckt werden, als bezüglich der Achse A parallele Flächen. Anschließend wird mit z.B. NH₄F/HF SiO₂ isotrop geätzt, bis das SiO₂ von den parallelen Flächen entfernt wird. SiO₂ an den senkrechten Flächen bilden eine Schutzschicht Ss (s. Fig. 2).

Anschließend wird durch thermische Oxidation ein Gatedielektrikum Gd erzeugt.

Anschließend wird in Situ dotiertes Polysilizium in einer Dicke von ca. 100nm abgeschieden und mit Hilfe einer dritten Maske aus Photolack, die die erste Ecke des inneren Bereichs bedeckt, geätzt, so, daß an den gegenüberliegenden Flanken der Schichtstruktur St eine Gateelektrode Ga in Form von Spacern entsteht (s. Fig. 2) und an der ersten Ecke des inneren Bereichs ein erster Kontakt entsteht, der die Gateelektrode Ga kontaktiert und einen ersten Teil der Gateelektrode Ga, der im inneren Bereich angeordnet ist und einen zweiten Teil der Gateelektrode Ga der außerhalb des inneren Bereichs angeordnet ist, elektrisch miteinander verbindet. Die Schutzschicht Ss verkleinert die Kapazität, die durch die Gateelektrode Ga und das zweite Source/Drain-Gebiet S/D2 gebildet wird.

Durch schräge Implantation wird das erste Source/Drain-Gebiet S/D1 so erweitert, daß es an die Gateelektrode Ga angrenzt (s. Fig 3). Die Gateelektrode Ga dient dabei als Maske.

Anschließend wird SiO₂ in einer Dicke von ca. 200nm abgeschieden und rückgeätzt, bis das erste Source-Drain-Gebiet S/D1 freigelegt wird. Dadurch entsteht eine erste isolierende Struktur I1 (s. Fig 3). Die Schutzschicht Ss wird dabei teilweise entfernt.

Zur Erzeugung einer Kontaktstruktur Ks wird Titan abgeschieden und selektiv siliziert. Übrigbleibendes Titan wird wieder mit z.B. NH₄OH/H₂O₂ entfernt (s. Fig 3).

Anschließend wird Aluminium in einer Dicke von ca. 500nm abgeschieden und mit Hilfe einer vierten Maske aus Photolack strukturiert. Dadurch entsteht ein zweiter Kontakt der das erste Source/Drain-Gebiet S/D1 kontaktiert.

Das zweite Source/Drain-Gebiet S/D2 wird nach dem Stand der Technik außerhalb des inneren Bereich kontaktiert.

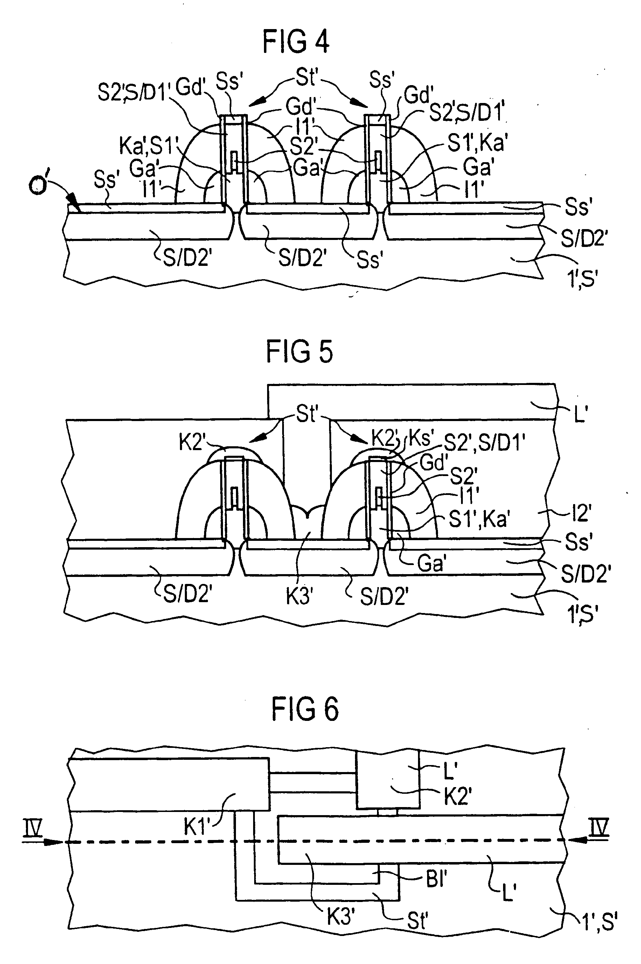

In einem Ausführungsbeispiel der Erfindung ist ein zweites Substrat 1' aus Silizium in einer an eine Oberfläche O' des zweiten Substrats 1' angrenzenden ca. 400µm dicken Schicht S' p-dotiert. Analog wie im Beispiel zur Erläuterung der Erfindung werden eine Schichtstruktur St' entlang Ränder eines inneren Bereichs BI', ein erstes Source-Drain-Gebiet S/D1', ein zweites Source/Drain-Gebiet S/D2', eine Schutzschicht Ss', ein Gatedielektrikum Gd', eine Gateelektrode Ga' und an einer ersten Ekke der Schichtstruktur St' ein erster Kontakt K1' erzeugt. Anschließend wird Siliziumnitrid in einer Dicke von ca. 170nm abgeschieden und mit Hilfe einer vierten Maske aus Photolack, die die erste Ecke der Schichtstruktur St' bedeckt, geätzt, so, daß die Gateelektrode Ga' durch eine erste isolierende Struktur I1' in Form eines Spacers aus Siliziumnitrid bedeckt wird (s. Fig 4). Durch Ãtzen von SiO₂ selektiv zu Siliziumnitrid mit z.B. HF/HNO₃ wird die Schutzschicht Ss' teilweise entfernt, so, daß ein Teil des zweiten Source/Drain-Gebiets S/D2' im inneren Bereich BI' sowie das erste Source/Drain-Gebiet S/D1' freigelegt werden (s. Fig. 5).

Zur Erzeugung von Kontaktstrukturen Ks' wird Titan abgeschieden und selektiv siliziert. Übrigbleibendes Titan wird wieder mit z.B. NH₄OH/H₂O₂ entfernt (s. Fig 5).

Zur Kontaktierung des ersten Source/Drain-Gebiets S/D1' und des zweiten Source/Drain-Gebiets S/D2' wird in Situ dotiertes Polysilizium abgeschieden und mit Hilfe einer fünften Maske aus Photolack, die die Schichtstruktur St' überlappt, geätzt, bis ein Teil des dotierten Polysiliziums, das an das zweite Source/Drain-Gebiet S/D2' angrenzt und als dritter Kontakt K3' dient, mit dem übrigen dotierten Polysilizium oberhalb des ersten Source/Drain-Gebiets S/D1', das als ein zweiter Kontakt K2' dient, nicht mehr verbunden ist (s. Fig. 5). Zur Erzeugung einer zweiten isolierenden Struktur I2' wird anschließend SiO₂ in einer Dicke von ca. 200nm abgeschieden und mit Hilfe einer sechsten Maske aus Photolack, die einen Teil des inneren Bereichs BI' und eine zweite Ecke der Schichtstruktur St' nicht bedeckt, geätzt, so, daß der zweite Kontakt K2' und der dritte Kontakt K3' freigelegt werden. Durch Abscheidung und Strukturierung von Aluminium werden leitende Strukturen L' erzeugt, die jeweils mit dem zweiten Kontakt K2' bzw. mit dem dritten Kontakt K3' verbunden sind, erzeugt (s. Fig 5 und 6).

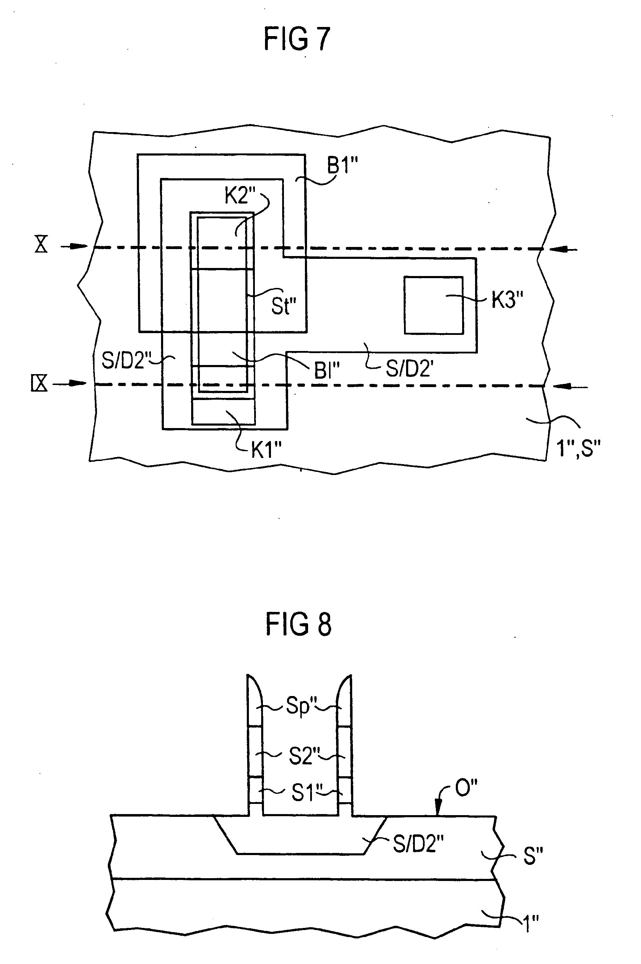

In einem weiteren Beispiel zur Erläuterung der Erfindung ist ein drittes Substrat 1'' aus Silizium in einer an eine Oberfläche O'' des dritten Substrats 1'' angrenzenden ca. 400 µm dicken Schicht S'' n-dotiert. Mit Hilfe einer Maske, die einen T-förmigen Bereich nicht abdeckt, wird durch Implantation ein n-dotiertes ca. 200 nm tiefes zweites Source/Drain-Gebiet S/D2'' eines Transistors erzeugt. Die Dotierstoffkonzentration des zweiten Source/Drain-Gebietes S/D2" beträgt ca. 10²¹cm⁻³ (siehe Figur 7). Innerhalb des T-förmigen Bereichs wird der Transistor gebildet.

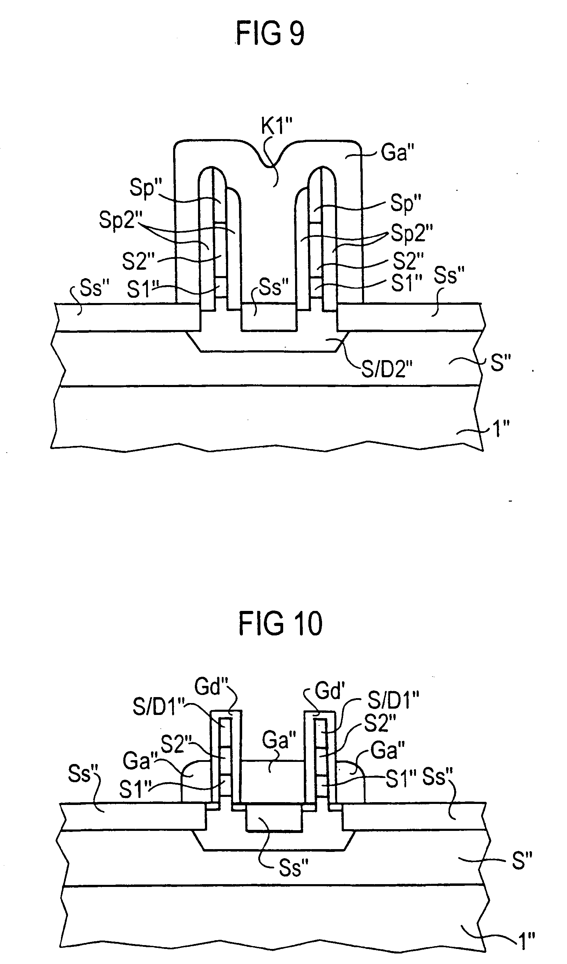

Anschließend wird durch Epitaxie auf der Oberfläche 0'' ganzflächig als Teil einer Schichtenfolge eine p-dotierte ca. 100nm dicke erste Schicht S1'' aufgewachsen. Die Dotierstoffkonzentration der ersten Schicht S1'' beträgt ca. 10¹⁸cm⁻³. Über der ersten Schicht S1''wird durch Epitaxie als Teil der Schichtenfolge eine ca. 200 nm dicke n-dotierte zweite Schicht S2'' aufgewachsen. Die Dotierstoffkonzentration beträgt ca. 5*10¹⁹cm⁻³. Anschließend wird analog wird wie im anderen Beispiel zur Erläuterung der Erfindung mit Hilfe von einem Spacer Sp'' eine Schichtstruktur St'' entlang Ränder eines inneren Bereichs BI'' erzeugt (s. Figur 8). Anschließend wird Siliziumnitrid in einer Dicke von ca. 50nm abgeschieden und rückgeätzt, so, daß an Flanken der Schichtstruktur St'' zweite Spacer Sp2'' entstehen (siehe Figur 9). Anschließend wird durch thermische Oxidation eine ca. 100nm dicke Schutzschicht Ss'' erzeugt (siehe Figur 9). Mit Hilfe einer zweiten Maske, die einen ersten Bereich B1'' der Schichtstruktur St'' bedeckt, wird Siliziumnitrid mit z.B. O₂/SF₆ geätzt, wodurch die zweiten Spacer Sp2" teilweise entfernt werden (siehe Figur 7 und 10).

Anschließend wird durch thermische Oxidation ein Gatedielektrikum Gd" erzeugt. Anschließend wird Polysilizium in einer Dicke von ca. 100nm abgeschieden und mit Hilfe einer Maske aus Photolack, die den ersten Bereich B1'' bedeckt, geätzt, so, daß an den Flanken der Schichtstruktur St'' eine Gateelektrode Ga'' in Form von Spacern entsteht (siehe Figur 10) und im ersten Bereich B1'' ein erster Kontakt K1'' entsteht (s. Fig. 7), der die Gateelektrode Ga'' kontaktiert und einen ersten Teil der Gateelektrode Ga'', der im inneren Bereich BI'' angeordnet ist, und einen zweiten Teil der Gateelektrode Ga'', der außerhalb des inneren Bereichs BI'' angeordnet ist, elektrisch miteinander verbindet. Die Schutzschicht Ss'' verkleinert eine Kapazität, die durch die Gateelektrode Ga'' und das zweite Source/Drain-Gebiet S/D2" gebildet wird. Die zweiten Spacer Sp2'' verkleinern eine Kapazität, die durch den ersten Kontakt K1'' und das zu erzeugende erste Source/Drain-Gebiet S/D1'' gebildet wird.

Anschließend wird durch Implantation in der zweiten Schicht S2'' das erste Source/Drain-Gebiet S/D1'' erzeugt, sowie die Gateelektrode Ga'' dotiert. Die Dotierstoffkonzentration beträgt ca. 10²¹cm⁻³ (siehe Figur 10).

Anschließend wird analog wie im anderen Beispiel zur Erläuterung der Erfindung eine erste isolierende Struktur, eine Kontaktstruktur, ein zweiter Kontakt K2" für das erste Source/Drain-Gebiet S/D1'' und ein dritter Kontakt K3" für das zweite Source/Drain-Gebiet S/D2" erzeugt (s. Fig. 7).

Wie im Ausführungsbeispiel der Erfindung kann das zweite Source/Drain-Gebiet alternativ auch innerhalb des inneren Bereichs kontaktiert werden.

Zur sicheren Kontaktierung des ersten Source/Drain-Gebiets kann bei der Erzeugung der Spacer eine Maske eingesetzt werden, die einen Bereich bedeckt, in dem der zweite Kontakt erzeugt wird. In diesem Bereich ist die Schichtstruktur breiter als 70 nm und kann dadurch leichter kontaktiert werden.

Es sind viele Variationen des Ausführungsbeispiels denkbar, die ebenfalls im Rahmen der Erfindung liegen. Insbesondere können die Abmessungen der beschriebenen Schichten, Gebiete, Bereiche und Strukturen an die jeweiligen Erfordernisse angepaßt werden. Dasselbe gilt auch für die vorgeschlagenen Dotierstoffkonzentrationen. Strukturen und Schichten aus SiO₂ können insbesondere durch thermische Oxidation oder durch ein Abscheidungsverfahren erzeugt werden. Isolierende Strukturen und die Schutzschicht können auch aus anderen isolierenden Materialen erzeugt werden. Polysilizium kann sowohl während als auch nach der Abscheidung dotiert werden. Statt dotiertem Polysilizium lassen sich auch z.B. Metallsilizide und/oder Metalle verwenden.

## Patentansprüche

1. Verfahren zur Herstellung eines vertikalen MOS-Transistors,
- bei dem mindestens teilweise als Teil des vertikalen MOS-Transistors eine Schichtstruktur (St') durch einen Ätzprozess gebildet wird,
- bei dem in der Schichtstruktur (St') mindestens ein erstes Source/Drain-Gebiet (S/D1') und bezüglich einer Achse (A), die senkrecht zu einer Oberfläche (O') eines Substrats (1') aus Halbleitermaterial verläuft, unterhalb des ersten Source/Drain-Gebiets (S/D1') eine Kanalschicht (Ka') gebildet werden,
- bei dem mindestens im Bereich der Kanalschicht (Ka') an zwei zur Achse (A) im Wesentlichen parallel verlaufenden gegenüberliegenden Flanken der Schichtstruktur (St') ein Gatedielektrikum (Gd') und eine Gateelektrode (Ga') gebildet werden,
- bei dem ein zweites Source/Drain-Gebiet (S/D2') bezüglich der Achse (A) unterhalb der Kanalschicht (Ka') gebildet wird,
- bei dem nach Erzeugung der Gateelektrode (Ga') eine erste isolierende Struktur (I1') erzeugt wird, in dem isolierendes Material abgeschieden und abgetragen wird, bis das erste Source/Drain-Gebiet (S/D1') freigelegt wird, und
- bei dem zur Kontaktierung des ersten Source/Drain-Gebiets (S/D1') leitendes Material abgeschieden wird,
wobei
- bei dem Ätzprozess ein erster Spacer (Sp) als Maske dient,
- die erste isolierende Struktur (I1') erzeugt wird, indem das isolierende Material abgeschieden und rückgeätzt wird, so, dass weitere Spacer entstehen, die die Gateelektrode (Ga') bedecken und so, dass ein Teil des zweiten Source/Drain-Gebiets (S/D2') innerhalb eines inneren Bereichs (BI'), der eine Grenzlinie aufweist, entlang mindestens eines Teils davon die Schichtstruktur (St') gebildet wird, freigelegt wird,
- zur Kontaktierung des ersten Source/Drain-Gebiets (S/D1') und zur Kontaktierung des zweiten Source/Drain-Gebiets (S/D2') das leitende Material(K2', K3')abgeschieden und mit Hilfe einer Maske geätzt wird, bis das erste Source/Drain-Gebiet (S/D1') und das zweite Source/Drain-Gebiet (S/D2') nicht mehr elektrisch miteinander verbunden sind,
- zur Isolierung des ersten Source/Drain-Gebiets(S/D1') vom zweiten Source/Drain-Gebiet (S/D2') weiteres isolierendes Material (I2') abgeschieden wird,
- zur Kontaktierung des zweiten Source/Drain-Gebiets (S/D2')das weitere isolierende Material (I2') mit Hilfe einer Maske geätzt wird, bis ein Teil des leitenden Materials, der an das zweite Source/Drain-Gebiet (S/D2') angrenzt, freigelegt wird, und
- anschließend weiteres leitendes Material (L') abgeschieden wird.

2. Verfahren nach Anspruch 1,
- bei dem zur Erzeugung des ersten Spacers (Sp) eine erste Hilfsschicht (H1) erzeugt wird, die mit Hilfe einer ersten Maske so strukturiert wird, dass sich eine Kante (Kn) bildet,
- bei dem nach der Erzeugung der strukturierten ersten Hilfsschicht (H1) eine zweite Hilfsschicht erzeugt und rückgeätzt wird, so, dass angrenzend an die Kante (Kn) der ersten Hilfsschicht (H1) aus der zweiten Hilfsschicht der erste Spacer (Sp) entsteht.

3. Verfahren nach Anspruch 1 oder 2,
- bei dem die Schichtstruktur (St') durch Strukturierung einer Schichtenfolge entsteht,
- bei dem für die Kanalschicht (Ka') eine von einem zweiten Leitfähigkeitstyp dotierte erste Schicht (S1') gebildet wird,
- bei dem für das erste Source/Drain-Gebiet (S/D1') eine von einem ersten, zum zweiten Leitfähigkeitstyp entgegengesetzten Leitfähigkeitstyp dotierte zweite Schicht (S2') gebildet wird.

4. Verfahren nach Anspruch 3,
- bei dem die erste Schicht (S1') und dann die zweite Schicht (S2') ganzflächig oberhalb der Oberfläche (O') epitaktisch aufgewachsen werden,
- bei dem nach der Erzeugung der ersten Schicht (S1') und der zweiten Schicht (S2') die erste Hilfsschicht (H1) bezüglich der Achse (A) oberhalb der zweiten Schicht (S2') erzeugt wird.

5. Verfahren nach einem der Ansprüche 1 bis 4,
- bei dem das erste Source/Drain-Gebiet (S/D1') und/oder das zweite Source/Drain-Gebiet (S/D2') nach der Erzeugung der Schichtstruktur (St') durch Implantation selbstjustiert erzeugt werden.

6. Verfahren nach einem der Ansprüche 1 bis 5,
- bei dem nach Erzeugung der Gateelektrode (Ga') durch schräge Implantation das erste Source/Drain-Gebiet (S/D1') so erweitert wird, dass es an die Gateelektrode (Ga') angrenzt, wobei die Gateelektrode als Maske wirkt.

7. Verfahren nach einem der Ansprüche 1 bis 6,
- bei dem nach Erzeugung des Gatedielektrikums (Gd') die Gateelektrode (Ga') in Form eines Spacers entlang allen Flanken der Schichtstruktur (St') entsteht, indem Material abgeschieden und geätzt wird.

8. Verfahren nach einem der Ansprüche 1 bis 7,
- bei dem ein Teil der Schichtstruktur (St') angeätzt wird, so, dass das erste Source/Drain-Gebiet (S/D1') in diesem Teil entfernt wird,
- bei dem ein erster Kontakt (K1') zur Gateelektrode (Ga') an diesem Teil der Schichtstruktur (St') gebildet wird.

9. Verfahren nach einem der Ansprüche 1 bis 8,
- bei dem die Schichtstruktur (St') stegförmig, und/oder entlang mindestens eines Teils einer Grenzlinie eines eckigen oder kreisförmigen inneren Bereichs (BI') des Substrats (1') gebildet wird.

10. Verfahren nach einem der Ansprüche 1 bis 9,
- bei der die Kanalschicht (Ka') an eine vom zweiten Leitfähigkeitstyp dotierte Schicht (S') des Substrats (1') angrenzt,
- bei dem das zweite Source/Drain-Gebiet (S/D2') bezüglich der Achse (A) im Wesentlichen lateral zu der Kanalschicht (Ka') und unter der Gateelektrode (Ga') gebildet wird.

## Claims

1. Method for producing a vertical MOS transistor,
- in which a layer structure (St') is formed at least partially as part of the vertical MOS transistor using an etching process,
- in which at least one first source/drain region (S/D1') and a channel layer (Ka') which is below the first source/drain region (S/D1') in relation to an axis (A) extending perpendicular to a surface (O') of a substrate (1') of semiconductor material, are formed in the layer structure (St'),
- in which one gate dielectric (Gd') and one gate electrode (Ga') are formed at least in the area of the channel layer (Ka') on two opposite flanks of the layer structure (St') which extends essentially parallel to the axis (A),
- in which a second source/drain region (S/D2') is formed below the channel layer (Ka') in relation to the axis (A),
- in which, after the gate electrode (Ga') has been produced, a first insulating structure (I1') is produced by depositing and eroding insulating material until the first source/drain region (S/D1') is exposed, and
- in which conductive material is deposited in order to make contact with the first source/drain region (S/D1'),
- in which
A first spacer (Sp) is used as a mask during the etching process,
- the first insulating structure (I1') is produced by depositing and etching back the insulating material so that further spacers which cover the gate electrode (Ga') are created and so that a part of the second source/drain region (S/D2') inside an inner area (BI'), which has a boundary, along at least a part of which the layer structure (St') is formed, is exposed,
- in order to make contact with the first source/drain region (S/D1') and in order to make contact with the second source/drain region (S/D2'), the conductive material (K2'/K3') is deposited and etched with the aid of a mask until the first source/drain region (S/D1') and the second source/drain region (S/D2') are no longer electrically connected to one another,
- further insulating material (I2') is deposited in order to insulate the first source/drain region (S/D1') from the second source/drain region (S/D2'),
- in order to make contact with the second source/drain region (S/D2'), the further insulating material (I2') is etched with the aid of a mask until a part of the conductive material next to the second source/drain region (S/D2') is exposed, and
- further conductive material (L') is then deposited.

2. Method according to Claim 1,
- in which, in order to produce the first spacer (Sp), a first auxiliary layer (H1) is produced and is structured with the aid of a first mask in such a way as to form an edge (Kn),
- in which, after the structured first auxiliary layer (H1) has been produced, a second auxiliary layer is produced and etched back so as to create the first spacer (Sp) from the second auxiliary layer, next to the edge (Kn) of the first auxiliary layer (H1).

3. Method according to Claim 1 or 2,
- in which the layer structure (St') is created by structuring a layer sequence,
- in which a first layer (S1') doped with a second conductivity type is formed for the channel layer (Ka'),
- in which a second layer (S2') doped with a first conductivity type, which is the opposite of the second conductivity type, is formed for the first source/drain region (S/D1').

4. Method according to Claim 3,
- in which the first layer (S1') and then the second layer (S2') are epitaxially grown surface-wide above the surface (O'),
- in which, after the first layer (S1') and the second layer (S2') have been produced, the first auxiliary layer (H1) is produced above the second layer (S2') in relation to the axis (A).

5. Method according to one of Claims 1 to 4,
- in which the first source/drain region (S/D1') and/or the second source/drain region (S/D2') are produced in self-aligned fashion by implantation after the layer structure (St') has been produced.

6. Method according to one of Claims 1 to 5,
- in which, after the gate electrode (Ga') has been produced by oblique implantation, the first source/drain region (S/D1') is widened so that it adjoins the gate electrode (Ga'), with the gate electrode acting as a mask.

7. Method according to one of Claims 1 to 6,
- in which , after the gate dielectric (Gd') has been produced, the gate electrode (Ga') is created in the form of a spacer along all the flanks of the layer structure (St'), by depositing and etching material.

8. Method according to one of Claims 1 to 7,
- in which a part of the layer structure (St') is partially etched so as to remove the first source/drain region (S/D1') in this part,
- in which a first contact (K1')with the gate electrode (Ga') is formed at this part of the layer structure (St').

9. Method according to one of Claims 1 to 8,
- in which the layer structure (St') is formed as a web, and/or along at least a part of a dividing line of a square or circular inner area (BI') of the substrate (1').

10. Method according to one of Claims 1 to 9,
- in which the channel layer (Ka') adjoins a layer(S'), doped with the second conductivity type, of the substrate (1'),
- in which the second source/drain region (S/D2') formed essentially laterally with respect to the channel layer (Ka') and below the gate electrode (Ga') in relation to the axis (A).

## Revendications

1. Procédé de fabrication d'un transistor MOS vertical,
- dans lequel on forme au moins en partie, en tant que partie du transistor MOS vertical, une structure (St') stratifiée par une opération d'attaque,
- dans lequel on forme, dans la structure (St') stratifiée, au moins une première zone (S/D1') de source/drain et, par rapport à un axe (A) qui est perpendiculaire à une surface (O') d'un substrat (1') en matériau semi-conducteur, une couche (Ka') de canal en dessous de la première zone (S/D1') de source/drain,
- dans lequel on forme, au moins dans la partie de la couche (Ka') de canal, sur deux flancs de la structure (St') stratifiée, opposée et s'étendant sensiblement parallèlement à l'axe (A), un diélectrique (Gd') de grille et une électrode (Ga') de grille,
- dans lequel on forme une deuxième zone (S/D2') de source/drain par rapport à l'axe (A) en dessous de la couche (Ka') de canal,
- dans lequel, après production de l'électrode (Ga') de grille, on produit une première structure (I1') isolante
dans laquelle on dépose du matériau isolant et on en enlève jusqu'à ce que la première zone (S/D1') de source/drain soit mise à nu, et
- dans lequel on dépose du matériau conducteur pour la mise en contact de la première zone (S/D1') de source/drain,
dans lequel
- dans l'opération d'attaque, on se sert d'un premier espaceur (Sp) comme masque,
- on produit la première structure (I1') isolante en déposant le matériau isolant et en l'attaquant en retrait, de manière à créer d'autres espaceurs qui recouvrent l'électrode (Ga') de grille et de manière à ce qu'une partie de la deuxième zone (S/D2') de source/drain soit mise à nu à l'intérieur d'une région (BI') intérieure qui a une ligne de démarcation, région le long d'au moins une partie de laquelle la structure (St') stratifiée est formée,
- pour la mise en contact de la première zone (S/D1') de source/drain et pour la mise en contact de la deuxième zone (S/D2') de source/drain, on dépose le matériau (K2', K3') conducteur et on l'attaque à l'aide d'un masque jusqu'à ce que la première zone (S/D1') de source/drain et la deuxième zone (S/D2') de source/drain ne soient plus reliées électriquement l'une à l'autre,
- pour isoler la première zone (S/D1') de source/drain de la deuxième zone (S/D2') de source/drain, on dépose du matériau (I2') isolant supplémentaire,
- pour mettre en contact la deuxième zone (S/D2') de source/drain, on attaque le matériau (I2') isolant supplémentaire à l'aide d'un masque jusqu'à mettre à nu une partie du matériau conducteur qui est voisin de la deuxième zone (S/D2') de source/drain, et
- on dépose ensuite du matériau (L') conducteur supplémentaire.

2. Procédé suivant la revendication 1,
- dans lequel, pour produire le premier espaceur (Sp), on produit une première couche (H1) auxiliaire qui est structurée à l'aide d'un premier masque, de façon à former un bord (Kn),
- dans lequel, après la production de la première couche (H1) auxiliaire structurée, on produit une deuxième couche auxiliaire et on l'attaque en retrait, de manière à créer le premier espaceur (Sp) au voisinage du bord (Kn) de la première couche (H1) auxiliaire à partir de la deuxième couche auxiliaire.

3. Procédé suivant la revendication 1 ou 2,
- dans lequel on crée la structure (St') stratifiée par structuration d'une suite de couches,
- dans lequel on forme, pour la couche (Ka') de canal, une première couche (S1') dopée par un deuxième type de conductivité,
- dans lequel on forme, pour la première zone (S/D1') de source/drain, une deuxième couche (S2') dopée d'un premier type de conductivité opposé au deuxième type de conductivité.

4. Procédé suivant la revendication 3,
- dans lequel on fait croître la première couche (S1') et ensuite la deuxième couche (S2') par épitaxie sur toute la surface au-dessus de la surface (O'),
- dans lequel, après la production de la première couche (S1') et de la deuxième couche (S2'), on produit la première couche (H1) auxiliaire par rapport à l'axe (A) au-dessus de la deuxième couche (S2').

5. Procédé suivant l'une des revendications 1 à 4,
- dans lequel on produit à autoalignement par implantation la première zone (S/D1') de source/drain et/ou la deuxième zone (S/D2') de source/drain après la production de la structure (St') stratifiée.

6. Procédé suivant l'une des revendications 1 à 5,
- dans lequel, après la production de l'électrode (Ga') de grille, on élargit par implantation inclinée la première zone (S/D1') de source/drain, de manière à ce qu'elle soit voisine de l'électrode (Ga') de grille, l'électrode de grille servant de masque.

7. Procédé suivant l'une des revendications 1 à 6,
- dans lequel, après la production du diélectrique (Gd') de grille, on crée l'électrode (Ga') de grille sous la forme d'un espaceur le long de tous les flancs de la structure (St') stratifiée en déposant et en attaquant du matériau.

8. Procédé suivant l'une des revendications 1 à 7,
- dans lequel on attaque une partie de la structure (St') stratifiée, de façon à éliminer dans cette partie la première zone (S/D1') de source/drain,
- dans lequel on forme un premier contact (K1') pour l'électrode (Ga') de grille sur cette partie de la structure (St') stratifiée.

9. Procédé suivant l'une des revendications 1 à 8,
- dans lequel on forme la structure (St') stratifiée en forme de barrette et/ou le long d'au moins une partie d'une ligne de démarcation d'une région (BI') intérieure du substrat (1') polygonale ou circulaire.

10. Procédé suivant l'une des revendications 1 à 9,
- dans lequel la couche (Ka') de canal est voisine d'une couche (S') du substrat (1') dopée par le deuxième type de conductivité,
- dans lequel on forme la deuxième zone (S/D2') de source/drain par rapport à l'axe (A) sensiblement latéralement à la couche (Ka') de canal et sous l'électrode (Ga') de grille.
